# EUROPEAN PATENT SPECIFICATION

(11) **EP 1 661 217 B1**
(45) Date of publication and mention of the grant of the patent: **03.12.2008**
(21) Application number: 04744803.0
(22) Date of filing: 20.08.2004
(51) Int. Cl.: H01S 3/063, H01S 3/094, H01S 3/23, H01S 5/40

(54) **WAVEGUIDE LASER LIGHT SOURCE SUITABLE FOR PROJECTION DISPLAYS**
WELLENLEITERLASERLICHTQUELLE GEEIGNET ZUR VERWENDUNG IN PROJEKTIONSANZEIGEN
SOURCE DE LUMIERE A LASER A GUIDE D'ONDES UTILISABLE DANS DES AFFICHAGES A PROJECTION

(30) Priority: 29.08.2003 EP 03102678
(43) Date of publication of application: 31.05.2006
(73) Proprietor: Philips Intellectual Property & Standards GmbH, 20099 Hamburg (DE); Koninklijke Philips Electronics N.V., 5621 BA Eindhoven (NL)
(72) Inventor: MÖNCH, Holger, 52066 Aachen (DE); HEUSLER, Gero, 52066 Aachen (DE)
(86) International application number: PCT/IB2004/051516
(87) International publication number: WO 2005/022708

(56) References cited:
- EP-A- 0 666 623
- US-A- 5 379 311
- US-A- 5 805 631
- DIAZ J ET AL: "THEORETICAL INVESTIGATION OF MINORITY CARRIER LEAKAGES OF HIGH-POWER 0.8 M INGAASP/INGAP/GAAS LASER DIODES" APPLIED PHYSICS LETTERS, AMERICAN INSTITUTE OF PHYSICS. NEW YORK, US, vol. 65, no. 18, 31 October 1994 (1994-10-31), pages 2260-2262, XP000476516 ISSN: 0003-6951
- MOORE A H ET AL: "THE PERFORMANCE AND RELIABILITY OF 800-880 NM INALGAAS-ALGAAS AND INGAAS/ALGAAS STRAINED LAYER RIDGE WAVEGUIDES LASERS" JOURNAL OF CRYSTAL GROWTH, NORTH-HOLLAND PUBLISHING CO. AMSTERDAM, NL, vol. 124, no. 1/4, 1 November 1992 (1992-11-01), pages 703-708, XP000411845 ISSN: 0022-0248

## Description

The invention relates to diode laser pumped waveguide lasers and their use as light source for replacement of a conventional arc lamp, in particular to upconversion waveguide lasers. Waveguide lasers of the present invention can be used as light source to replace conventional arc lamps such as for projection displays as well as for various lighting applications, e.g. headlight, shop, home, accent, spot or theater lighting.

A laser diode is a semiconductor device that produces coherent radiation in which the waves are all at the same frequency and phase in the visible or infrared (IR) spectrum when current passes through it. Waveguide lasers comprise a laser diode as a pump source and a waveguide structure in which the pump radiation of the diode laser is absorbed and converted to a different wavelength. Laser diodes and waveguide lasers are used in optical fiber systems, compact disc (CD), as pump source for solid state lasers, laser printers, remote-control devices, intrusion detection systems and for material processing like welding or cutting.

US 5,379,311 refers to a radiation wavelength conversion device in the form of a waveguide that includes a single crystal halide- based cladding layer and a halide-based active layer, which preferably has a suitable thickness to induce single-mode propagation.

US 5,805,631 refers to a laser for outputting visible light at the wavelengths of blue, green, orange and red light. This is accomplished through the doping of a substrate, such as an optical fiber or waveguide, with Pr³⁺ ions and Yb³⁺ ions. The host substrate material can be a crytalline material or glass or a combination of both. A light pump such as a diode laser is used to excite these ions into energy states that will produce lasing at the desired wavelengths. Further, tuning elements such as prisms and gratings can be employed to select desired wavelengths for output.

US-A 5436919 discloses a multi wavelength upconversion waveguide laser producing visible or ultraviolet wavelength radiation comprising a semiconductor laser diode producing relatively long wavelength radiation, a channel waveguide having a thin film material which converts the relatively long wavelength radiation into visible or ultraviolet wavelength radiation, and an optical resonator which recirculates the visible or ultraviolet wavelength radiation. The optical resonator may use an output optical coating or one or more Bragg grating reflectors as an output coupler. One or more optical resonators may be used to produce one or more visible or ultraviolet radiation wavelengths. One or more independently controllable light wave modulators are used to modulate the visible or ultraviolet wavelength radiation. It is disclosed in US-A 5436919 that the thin film material has a thickness of 0.7 µm to 2.0 µm.

Thus diode lasers and in addition upconversion waveguide lasers are generally known in prior art.

However, there exists a long need to simplify the manufacture process of waveguide lasers, in order to provide said waveguide laser with a low vertical range of manufacture, a small number of components, increased robustness, improved compactness and low costs, in order to provide a light source which has ray performance superior or comparable with arc lamps so that said waveguide laser can be used as light source having better or similar radiation performance to replace arc lamps.

The invention is defined in the independent claims. Embodiments of the invention are set out in the dependent claims.

It is the object of this invention to overcome the above drawbacks by providing a waveguide laser having a similar radiation performance to arc lamps. The waveguide laser light source of the present invention is easier to produce, more compact, and more similar to arc lamps compared with laser diodes known in prior art.

This object is achieved in a waveguide laser producing visible wavelength radiation from IR wavelength radiation comprising: a) at least one semiconductor diode laser or laser bar producing IR wavelength radiation wherein the emitting layer comprises at least two waveguide layers; b) at least one upconversion layer that converts the IR wavelength radiation into visible wavelengths by an upconversion process of photon absorption energy transfer followed by emission; c) at least one optical resonator which recirculates the visible wavelength radiation; whereby - the thickness of the upconversion layer is at least 1 µm thicker than the thickness of the emitting layer in the semiconductor diode laser; - the laser diode or laser diode bar and the upconversion layer are arranged on the same substrate or each on a separate substrate; - the laser diode or laser diode bar and the upconversion layer are adjacent arranged, whereby a gap between the adjacent arranged diode laser or diode laser bar and the upconversion layer is formed; or - the laser diode or laser diode bar and the upconversion layer are contactingly arranged in this order, and whereby the waveguide laser has an optical beam quality M² of ≥ 2 and ≤ 1000 and the upconversion layer comprises amorphous glass.

This object can also be achieved in a waveguide laser producing visible wavelength radiation from IR wavelength radiation comprising: a) at least one semiconductor diode laser or laser bar producing IR wavelength radiation wherein the emitting layer comprises at least two waveguide layers, b) at least one upconversion layer that converts the IR wavelength radiation into visible wavelengths by an upconversion process of photon absorption energy transfer followed by emission; c) at least two waveguide layers that carry the IR wavelength radiation; d) at least one optical resonator which recirculates the visible wavelength radiation; whereby
- the upconversion layer is placed between said two waveguide layers which have a refractive index smaller than the refractive index of the upconversion layer;
- the total thickness of the upconversion layer and the two waveguide layers is at least 1 µm thicker than the thickness of the emitting layer in the semiconductor diode laser
- the laser diode or laser diode bar and the upconversion layer are arranged on the same substrate or each on a separate substrate;
- the laser diode or laser diode bar and the upconversion layer are adjacent arranged, whereby a gap between the adjacent arranged diode laser or diode laser bar and the upconversion layer is formed; or
- the laser diode or laser diode bar and the upconversion layer are contacting arranged; and whereby the waveguide laser has an optical beam quality M² of ≥ 2 and ≤1000.

It has been surprisingly found by the inventors that an upconversion waveguide laser can be adapted to have similar radiation performance to arc lamps in that the optical beam quality M² is adjusted to ≥ 2 and ≤ 1000. This is achieved in that the thickness of the upconversion layer is at least 1 µm thicker than the thickness of the emitting layer in the semiconductor diode laser.

The term "optical resonator" as used in the present descriptions comprises at least two mirrors which recirculate the visible wavelength radiation and/or which recirculates the IR wavelength radiation.

The term "emitting layer" as used in the present descriptions means the layers in a laser diode or a laser diode bar that carry the laser light and determine the size of the lasing spot of each single emitter. These layers comprise in a typical laser diode two waveguide layers sandwiching a quantum-well structure with a typical overall thickness of at least 1 µm for IR laser diodes.

The term "upconversion layer" as used in the present descriptions means a layer structure that consists preferably of a rare earth doped ZBLAN layer, e. g. ZBLAN : Er that carries the incoupled IR light and the visible light emitted by the rare earth ions by an upconversion process of photon absorption energy transfer followed by emission. The upconversion layer can be placed between two layers of lower refractive index, e.g. consisting of ZBLAN with a different stoichiometric composition. Also, the upconversion layer can be placed between two waveguide layers of lower refractive index, e.g. consisting of ZBLAN with a different stoichiometric composition, that in turn can be placed between two layers of lower refractive index than the waveguide layer, e. g. consisting of ZBLAN with a stoichiometric composition differing from the upconversion layer and the waveguide layer.

The thickness of the upconversion layer or, respectively, the total thickness of the upconversion layer and the two waveguide layers, can be of at least 2.1 µm, preferably of at least 2.5 µm and more preferably of at least 3 µm. Further, the thickness of the upconversion layer or, respectively, the total thickness of the upconversion layer and the two waveguide layers, can be of at least 3.5 µm or of at least 4 µm or of at least 5 µm or of at least 6 µm.

The term "waveguide layer" as used in the present description means a layer that consists preferably of undoped ZBLAN and carries the incoupled IR light, but not the visible light or only a minor fraction of the visible light.

In case a waveguide laser of the present invention comprises a laser diode stack then the thickness of the upconversion layer or, respectively, the total thickness of the upconversion layer and the two waveguide layers, is at least 1 µm thicker than the thickness of each adjacent emitting layer of the adjacent laser diode stack.

The waveguide laser according to the present invention has an optical beam quality M² of ≥ 2 and ≤ 1000, also preferably of ≥ 2.5 and ≤ 200, further preferably of ≥ 3 and ≤ 150, more preferably of ≥ 3.5 and ≤ 100, most preferably of ≥ 4 and ≤ 50.

Projection display systems have high demands on the light source, therefore UHP lamps are generally used, i.e. short arc high pressure discharge lamps. It has now been surprisingly found by the inventors that the waveguide laser of the present invention can be used instead of arc lamps for projection displays. Further, the number of optical components in such a projection system becomes redundant when using a laser light source of the present invention instead of an arc lamp. Furthermore, the waveguide laser of the present invention preferably has an optical conversion efficiencies of more than 5 %, preferably of more than 7 % and more preferably of more than 10%. The optical conversion efficiency is the ratio of the visible light output of the waveguide laser to the electric power input to the laser diode or laser diode bar.

The thickness of the upconversion layer or, respectively, the total thickness of the upconversion layer and the two waveguide layers, is at least 1 µm more than the thickness of the emitting layer in the semiconductor diode laser and converts the IR wavelength radiation into visible wavelengths by an upconversion process of photon absorption energy transfer followed by emission may consist of a fluoride glass known as ZBLAN, consisting of the components ZrF₄, BaF₂, LaF₃, AlF₃ and NaF, doped with one or more rare earth ions from the group Er, Yb, Pr, Tm, Ho, Dy, Eu, Nd or a combination thereof or one of the crystalsLiLuF₄, LiYF₄, BaY₂F₈, SrF₂, LaCl₃, KPb₂Cl₅, LaBr₃ doped with one or more rare earth ions as above or a rare earth doped metal fluoride such as Ba-Ln-F or Ca-Ln-F, where Ln is one or more rare earth ions as above ZBLAN materials are further described in K. Ohsawa, T. Shibita, Preparation and characterization of ZrF4-BaF2-LaF3-NaF-AlF3 glass optical fibers, Journal of Lightwave Technology LT-2 (5), 602 (1984).

For example, the upconversion layer may consist of a glass layer of Er doped ZBLAN deposited on a ZBLAN layer on a copper substrate. Alternatively, the upconversion layer may consist of Yb, Er doped ZBLAN. According to the present invention rare earth metals comprising in the group of Er, Ho, Nd, Pr, Pr/Yb and/or Tm are preferred. However, production techniques to make such upconversion layers are generally known in the art. Rare earth doped metals which can be used for upconversion layers according to the present invention are disclosed e. g. in US-B1 6510276.

A conventional semiconductor IR laser diode serves as an optical pump. The semiconductor laser diode should operate at a wavelength between 790 nm and 1150 nm. It is recognized that other rare earth dopants may require different pump wavelengths. The power requirements will vary according to the upconversion layer. Preferably, the IR output powers of a diode laser bar or stack used according to the present invention can be ≥ 20 W, more preferably ≥ 50 W. The IR output power of a single laser diode should be ≥1 W, more preferably ≥ 2 W.

According to the present invention at least one frequency-converting layer consisting of an upconversion layer and of at least one optical resonator which recirculates the visible wavelength radiation is in contact with the IR diode laser or diode laser bar or diode laser stack. In more detail, the IR wavelength radiation of the IR diode laser or diode laser bar or stack is upconverted by means of rare-earth doped upconversion layer, e.g. glass or crystal layer, which are positioned in front of the diode laser or diode laser bar.

An IR diode laser or diode laser bar or stack and an upconversion layer can be placed on the same substrate or on separate substrates. The substrate can be of glass material and/or ceramic and/or metal, e.g. copper, preferably the substrate is of a material with high heat conductivity to allow efficient cooling of the device.

According to a first embodiment of the present invention an IR diode laser or diode laser bar arranged on a substrate is sandwiched between one n-electrode and one p-electrode. The upconversion layer is arranged on the same substrate positioned adjacent in front of the IR diode laser or laser bar. The visible laser can be realized in the form of an intracavity or extracavity arrangement. In the case of an extracavity arrangement, the laser diode or the laser diode bar comprises a mirror with a high reflectivity for the desired IR wavelength on the one side and an outcoupling mirror as known in the art on the other side where the upconversion layer is located. These mirrors are typically realized as dichroic coatings on the end facets of the diode laser or diode laser bar. A second resonator is formed by two mirrors at both ends of the upconversion layer structure. One mirror placed between the IR diode laser and the upconversion layer structure is highly reflective at the desired visible wavelength, the other mirror at the end of the device serves as the outcoupling mirror as known in the art. These mirrors can also be realized in the form of dichroic coatings. In the case of an intracavity arrangement, the IR output mirror is placed at the end of the device, i.e. at the end of the upconversion layer. In this case, the mirror may comprise a high reflectivity for the desired IR wavelength. In case of an intracavity arrangement of an IR diode laser, i.e. no IR mirror is placed between the IR diode laser and the upconversion layer, it is preferred that a mirror reflective for visible wavelength radiation but transmissive for IR wavelength radiation is placed between the IR diode laser bar or stack and the upconversion layer at the side of the upconversion layer.

According to a second embodiment of the present invention an IR diode laser or diode laser bar is arranged on a first substrate and is sandwiched between one n-electrode and one p-electrode. The upconversion layer is arranged on a second substrate positioned in front of the IR diode laser or laser bar. The visible laser can be realized in the form of an intracavity or extracavity arrangement. In the case of an extracavity arrangement, the laser diode or the laser diode bar comprises a mirror with a high reflectivity for the desired IR wavelength on the one side and an outcoupling mirror as known in the art on the other side where the upconversion layer is located. These mirrors are typically realized as dichroic coatings on the end facets of the diode laser or diode laser bar. A second resonator is formed by two mirrors at both ends of the upconversion layer structure. One mirror placed between the IR diode laser and the upconversion layer structure is highly reflective at the desired visible wavelength, the other mirror at the end of the device serves as the outcoupling minor as known in the art. These mirrors can also be realized in the form of dichroic coatings. In the case of an intracavity arrangement, the IR output mirror is placed at the end of the device, i.e. at the end of the upconversion layer. In this case, the mirror may comprise a high reflectivity for the desired IR wavelength. In case of an intracavity arrangement of an IR diode laser, i.e. no IR mirror is placed between the IR diode laser and the upconversion layer, it is preferred that a mirror reflective for visible wavelength radiation but transmissive for IR wavelength radiation is placed between the IR diode laser bar or stack and the upconversion layer at the side of the upconversion layer.

According to the present invention a waveguide laser light source can comprise at least 1, preferably at least 5, more preferably at least 10, most preferably at least 20 diode laser emitters, i.e. one laser diode bar.

Alternatively, a waveguide laser light source according to the present invention can comprise:
- a stack of more than one semiconductor diode laser bar producing IR wavelength radiation; and comprising an upconversion layer that converts the IR wavelength radiation into visible wavelengths by an upconversion process of photon absorption energy transfer followed by emission as described above.

A waveguide laser light source according to present invention may have a gap between the adjacent arranged diode laser or diode laser bar and the upconversion layer of ≥ 0 µm and ≤ 10 µm. However, it is preferred that between the adjacent arranged diode laser or diode laser bar, mirror material of at least one optical resonator and upconversion layer no gap is formed. If a gap is formed between the adjacent arranged diode laser bar, mirror material of at least one optical resonator and the upconversion layer the gap is preferably filled with a filling material, such as an index-matching liquid or gel known in the art.

The gap can be of ≥ 0.1 µm and ≤ 9 µm, preferably ≥ 0.2 µm and ≤ 8 µm, further preferably ≥ 0.3 µm and ≤7.0 µm, also preferably ≥ 0.5 µm and ≤ 6.0 µm and more preferably ≥ 0.7 µm and ≤ 6.0 µm. However, the gap can be of ≥ 0.4 µm and ≤ 5 µm, or ≥ 0.8 µm and ≤ 4 µm, or ≥ 0.9 µm and ≤ 3.0 µm, or ≤ 1.0 µm and ≤ 2.0 µm.

Exemplary embodiments of the present invention will be described in the following, with reference to the following drawings:
Fig. 1 shows a schematic side view of a waveguide laser located on one substrate;
Fig. 2 shows a schematic side view of a waveguide laser located on two substrates;
Fig. 3 shows a schematic view of a waveguide laser with a laser diode bar of three emitters and three upconversion layers located on one substrate;
Fig. 4 shows a schematic view of a waveguide laser with a laser diode bar of three emitters and three upconversion layers located on two substrates;
Fig. 5 shows a schematic side view of a waveguide laser located on one substrate in which the upconversion layer is placed between two waveguide layers
Fig. 6 shows a schematic side view of a waveguide laser located on two substrates in which the upconversion layer is placed between two waveguide layers

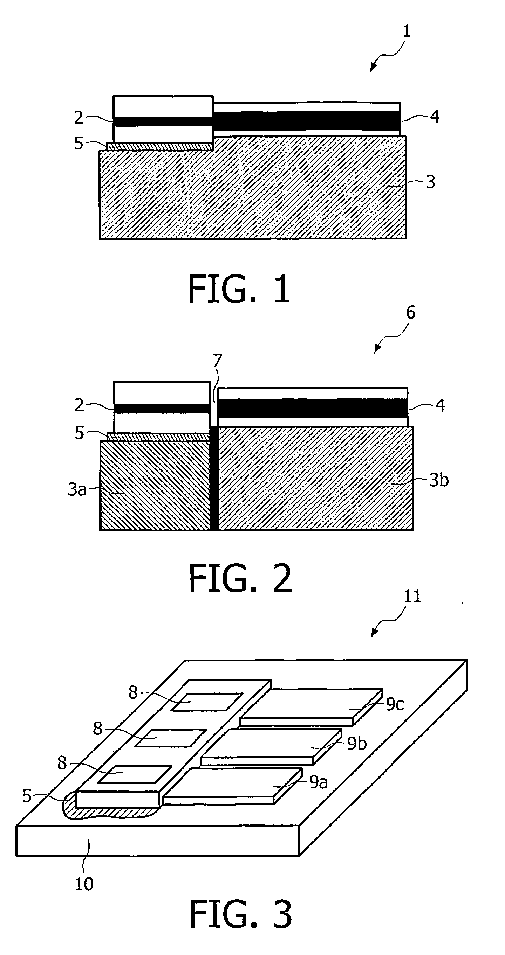

Fig. 1 shows a schematic side view of a waveguide laser (1) consisting of a laser diode bar (2) that is soldered with a soldering layer (5) to a substrate (3). On the same substrate (3) an upconversion layer (4) is placed. The upconversion layer is of ZBLAN : Er and placed between two layers of lower refractive index e.g. consisting of ZBLAN with a different stoichiometric composition.

Fig. 2 shows a schematic side view of the waveguide laser (6) consisting of a laser diode bar (2) that is soldered with a soldering layer (5) to a first substrate (3a). On a separate second substrate (3b) an upconversion layer (4) of ZBLAN : Er is placed, whereby said upconversion layer is arranged between two layers of lower refractive index e.g. consisting of ZBLAN with a different stoichiometric composition. This second substrate (3b) is positioned adjacent to the first substrate (3a) and between the laser diode bar (2) and the upconversion layer (4) is a gap (7) filled with a material having a index of refraction between the index of refraction of the diode laser bar (2) and the index of refraction of the upconversion layer (4).

Fig. 3 shows a schematic view of a waveguide laser (11) consisting in this case of a laser diode bar of three emitters (8) that is soldered with a soldering layer (5) to a substrate (10) and three upconversion layers (9a; 9b, 9c) placed in front of the emitter output facets on the same substrate (10). In this case, the three individual upconversion lasers (9a; 9b, 9c) emit red (9a), green (9b) and blue light (9c).

According with another embodiment of the present invention a waveguide laser consisting of a laser diode bar of three emitters and three upconversion layers placed in front of the emitter output facets on the same substrate. In this case, the three individual upconversion lasers emit light of only one color. However, a waveguide laser according to the present invention can possess more or less emitters in one device and emit light of one or more colors (in particular also more than three colors)

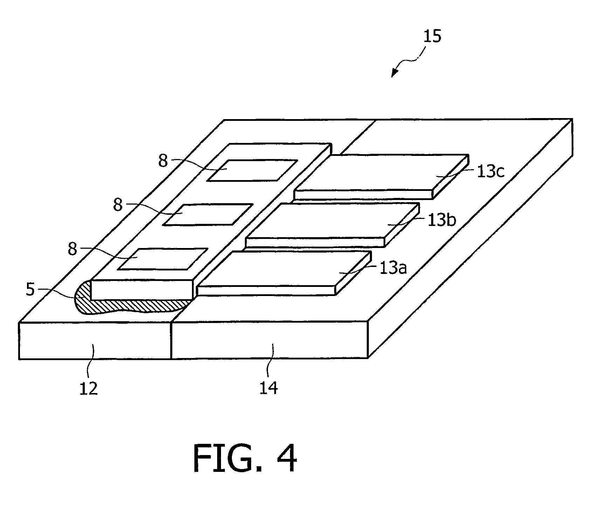

Fig. 4 shows a schematic view of a waveguide laser (15) consisting of a laser diode bar of three emitters (8) soldered with a soldering layer (5) to a first substrate (12) and three upconversion layers (13a; 13b, 13c) soldered to a separate second substrate (14). The three upconversion layers (13a; 13b, 13c) soldered to said second substrate (14) are placed in front of the emitter output facets of the diode laser bar on the first substrate (12). In this case, the three individual upconversion lasers (13a; 13b, 13c) emit red (13a), green (13b) and blue light (13c).

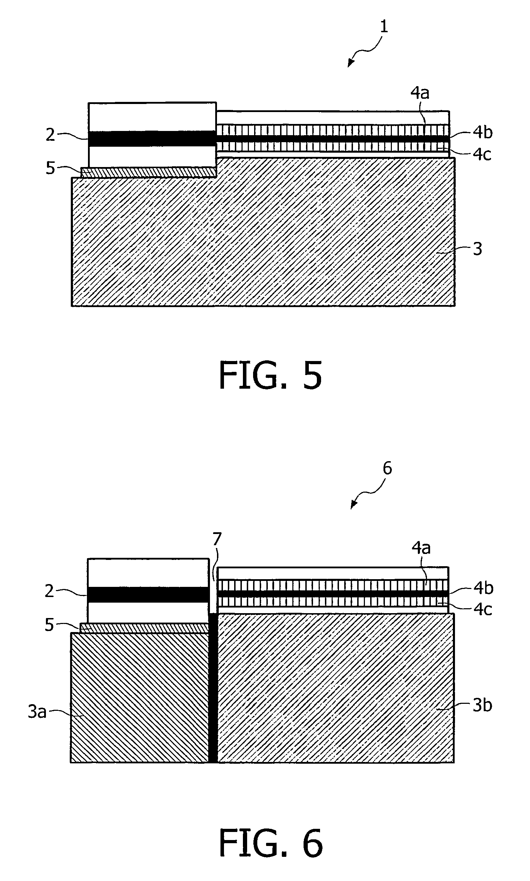

Fig. 5 shows a schematic side view of a waveguide laser (1) consisting of a laser diode bar (2) that is soldered with a soldering layer (5) to a substrate (3). On the same substrate (3) an upconversion layer (4b) is placed. The upconversion layer is of ZBLAN : Er and placed between two waveguide layers (4a, 4c) of lower refractive index e.g. consisting of ZBLAN with a different stoichiometric composition. The upconversion layer (4b) and the two waveguide layers (4a, 4c) can in turn be placed between two layers of lower refractive index than the waveguide layers, e. g. consisting of ZBLAN with a stoichiometric composition differing from the upconversion layer and the waveguide layer.

Fig. 6 shows a schematic side view of the waveguide laser (6) consisting of a laser diode bar (2) that is soldered with a soldering layer (5) to a first substrate (3a). On a separate second substrate (3b) an upconversion layer (4b) of ZBLAN : Er is placed, whereby said upconversion layer is arranged between two waveguide layers (4a, 4c) of lower refractive index e.g. consisting of ZBLAN with a different stoichiometric composition. The upconversion layer (4b) and the two waveguide layers (4a, 4c) can in turn be placed between two layers of lower refractive index than the waveguide layers, e. g. consisting of ZBLAN with a stoichiometric composition differing from the upconversion layer and the waveguide layer. This second substrate (3b) is positioned adjacent to the first substrate (3a) and between the laser diode bar (2) and the upconversion layer (4) is a gap (7) filled with a material having a index of refraction between the index of refraction of the diode laser bar (2) and the index of refraction of the upconversion layer (4).

However, the waveguide laser of Fig.4 can be implemented so that the three individual upconversion lasers (13a; 13b, 13c) emit light of only one colour and/or said waveguide laser possess more or less emitters and emit light of one or more colors, in particular more than three colors.

When the diode laser end facet is coated with an end mirror that is partially transmissive in the infrared, the upconversion layer end facet pointing to the IR diode laser end facet is coated with a highly reflective coating in the visible wavelength and highly transmissive in the infrared it is preferred that the gap between the adjacent diode laser and upconversion layer is filled with a material translucent for visible wavelength radiation and/or infrared wavelength radiation whereby the filling material has preferably a index of refraction between the index of refraction of the diode laser or diode laser bar and the index of refraction of the upconversion layer.

More preferably the filling material has an index of refraction not deviating by more than 0.2, preferably by more than 0.1, from the index of refraction of the laser bar or from the index of refraction of the upconversion material or from the index of refraction of the waveguide layer(s).

When the diode laser end facet is coated with an end mirror that is partially transmissive in the infrared and highly reflective in the visible wavelength it is preferred that the gap between the adjacent diode laser and upconversion layer is filled with a material translucent for visible wavelength radiation and infrared wavelength radiation whereby the filling material has a index of refraction that differs not more than 0.2 from the index of refraction of the upconversion layer.

Further, a waveguide laser according to present invention can have:
- a length of the upconversion layer that is ≥ 100 µm and ≤ 100,000 µm, preferably ≥ 200 µm more preferably ≥ 500 µm and most preferably ≥ 1000 µm < 50,000 µm; and/or
- a width of the upconversion layer that has approximately the same width as the emitting layer of the diode laser, preferably >1 µm wider than the said emitter width, but not more than 200 µm wider than the said emitter width; and/or
- a thickness of the upconversion layer or, respectively, the total thickness of the upconversion layer and the two waveguide layers, that is by at least 1 µm thicker than the thickness of the emitting layer of the diode laser, preferably 2 µm thicker than said emitter thickness, but not more than 20 µm thicker than said emitter thickness.

However, the thickness of the upconversion layer or, respectively, the total thickness of the upconversion layer and the two waveguide layers, at least is 1 µm thicker than the thickness of the emitting layer of the diode laser, preferably at least 1.5 µm thicker than the thickness of the emitting layer of the diode laser and more preferably at least 2 µm thicker than the thickness of the emitting layer of the diode laser. Further, the thickness of the upconversion layer or, respectively, the total thickness of the upconversion layer and the two waveguide layers, can be at least 2.5 µm thicker than the thickness of the emitting layer of the diode laser, at least 3 µm thicker than the thickness of the emitting layer of the diode laser, at least 4 µm thicker than the thickness of the emitting layer of the diode laser or at least 5 µm thicker than the thickness of the emitting layer.

Individual IR diode lasers can be conductively contacted such that each IR diode laser can be controlled separately and/or groups of IR diode lasers are conductively contacted such that a group of IR diode lasers are conjointly operated. For example, a group of IR diode lasers can be a number of IR diode lasers producing the same colour or different colours in the respective upconversion layer(s).

In a preferred embodiment of the present invention a light source is provided comprising a number of waveguide laser groups, whereby a number of red colour, green colour and blue colour emitting waveguide lasers are conjointly operated each allowing a time-sequential operating of waveguide lasers with different colours. This allows for example to adapt the output power of different visible wavelength radiation, i.e. different colours, by varying the electric power of the respective IR diode laser and/or of the conjointly operated IR diode lasers.

Further, an IR diode laser group can also comprise individual IR diode lasers used to pump waveguides, such as upconversion layers, leading to different colours. However, it is preferred that a group of IR diode lasers are used to pump waveguides, such as upconversion layers, leading to the same colour output.

It is further preferred that a number of IR diode laser groups used to pump waveguides of the same colour output can be operated such that each group can be addressed individually.

The individual operating of an IR diode laser, i.e. the IR diode laser is individually conductively contacted, offers the possibility to switch off an IR diode laser which has a malfunction. Furthermore, it allows to avoid shortcuts or unneeded heat generation of IR diode lasers having a malfunction.

It is intended that a waveguide laser of the present invention can be build up such that a diode laser bar or stack is adjacent arranged to at least one upconversion layer. However, a diode laser bar or stack according to the present invention can comprise at least one upconversion layers. In general, each upconversion layer converts the IR wavelength into a specific visible wavelength, preferably to one colour of the primary colours red (R) green (G) or blue (B). The upconversion layers are adjacent arranged on the same or separate substrates to produce a R-G-B pattern and/or the upconversion layers are adjacent arranged to produce an alternating R/G/B or repeating R-G-B pattern.

In the manufacturing process, it is possible to start with one upconversion layer adjacent arranged to a diode laser bar on the same or separate substrates. The lateral structuring of this initially one upconversion layer can be done using one of the known techniques of e.g. lithography, removal by laser ablation, mechanic removal or modification of the refractive index by e.g. ion bombardement or UV treatment.

In a more preferred embodiment an IR laser diode of the present invention comprises one diode laser bar positioned on a substrate and three upconversion layers positioned on the same substrate or on a separate substrate, whereby the laser bar and the three up-converting layers are adjacent arranged to each other, whereby the first upconversion layer having an output of blue light, the second upconversion layer having an output of green light and the third upconversion layer having an output of red light.

Each upconversion layer is positioned in front of one single emitter facet of the diode laser. In case of a diode laser bar, there is thus to each emitter one separate upconversion layer of the same or different material and/or doping (see Fig. 3 and 4).

To increase the optical power level, at least two upconversion layers can be used when the IR diode laser comprises at least two lasers or a stack of two or more diode laser bars.

An upconversion layer placed between two waveguide layers of lower refractive index, e.g. consisting of undoped ZBLAN with a different stochiometric composition can be bonded in front adjacent to the IR diode laser bar or stack or deposited there, e.g. by pulsed laser deposition (PLD).

Subsequently, the present invention is explained in more detail on an example based on a waveguide laser according to the present invention with upconversion layers having an output of the three primary colors at the wavelengths 455 nm, 544 nm and 635 nm with an IR to visible conversion efficiency for example of 16%, 20% and 10%, respectively.

In a projection display with 1000 screen lumens and an optical efficiency of about 50%, comparable to a white light color balance of D65, a laser light source has to deliver 2.1 W of red (635 nm), 2.2 W of green (544 nm) and 2.4 W of blue light (455 µm). According to optical conversion efficiencies as mentioned above, assuming that for 50 W IR 20 IR diode lasers are used in one bar, whereby 9 IR diode lasers are necessary to convert to red light, 5 IR diode laser are necessary to convert to green light and 6 IR diode laser are necessary to convert to blue light. To achieve exact balancing of the primary colors in the example above it can be necessary that the IR diode laser power of at least one of IR diode lasers used to pump the green and the red lasers may be adjusted slightly reduced compared with the other IR diode lasers used to pump the blue laser. This is achieved for example when the IR diode lasers are contacted either individually and/or all IR diode lasers of the same color output are contacted as one group, as it has been described before. Alternatively, by adapting the green and red output power, the color point can be shifted.

The individually addressed IR diode laser or groups of IR diode lasers used to pump waveguides with an output of one of the primary colors is advantageously for following reasons:
- the power levels of the primary colors can be changed individually or by groups
- the IR laser diodes can be activated individually or by groups at different times, e. g. in a time sequential mode where in the first time slot red, in the second time slot green and in the third time slot blue light is produced.

This is of advantage in all single panel displays and allows to work without a color wheel or color filter commonly used in combination with white light sources. The length of the time slots may be the same, but it may also be chosen to be different for the primary colors. In the latter case, this allows a further improvement to balance the colors than described above where the power level is adapted. The different power levels can be adapted by choosing a shorter timescale for one primary color with respect to the others to reduce the effective optical power of each color in the projection system.

Another object of the present invention relates to a lighting unit comprising at least one of the waveguide lasers of the present invention being designed for the usage in one of the following applications: shop lighting, - home lighting, - accent lighting, - spot lighting, - theater lighting, - automotive headlighting, - fiber-optics applications, and - projection systems.

## Claims

1. A waveguide laser producing visible wavelength radiation from IR wavelength radiation comprising:
a) at least one semiconductor diode laser (2) or diode laser bar (8) producing IR wavelength radiation, wherein the emitting layer comprises at least two waveguide layers;
b) at least one upconversion layer (4) that converts the IR wavelength radiation into visible wavelengths by an upconversion process of photon absorption energy transfer followed by emission;
c) at least one optical resonator which recirculates the visible wavelength radiation; whereby
- the laser diode (2) or laser diode bar (8) and the upconversion layer(s) (4) are arranged on the same substrate (3) or each on a separate substrate (3a, 3b);
- the laser diode (2) or laser diode bar (8) and the upconversion layer(s) (4) are adjacently arranged, whereby a gap (7) between the adjacently arranged laser diode (2) or diode laser bar (8) and the upconversion layer(s) (4) is formed; or
- the laser diode (2) or laser diode bar (8) and the upconversion layer(s) (4) are contactingly arranged in this order;
- the upconversion layer comprises amorphous glass
- the at least one upconversion layer (4) has a thickness of at least 1 µm thicker than the thickness of the emitting layer in the semiconductor diode laser; and
- the waveguide laser has a beam quality M² of ≥ 2 and ≤1000.

2. A waveguide laser producing visible wavelength radiation from IR wavelength radiation comprising:
a) at least one semiconductor diode laser (2) or diode laser bar (8) producing IR wavelength radiation, wherein the emitting layer comprises at least two waveguide layers;
b) at least one upconversion layer (4b) that converts the IR wavelength radiation into visible wavelengths by an upconversion process of photon absorption energy transfer followed by emission;
c) at least two waveguide layers (4a, 4c) that carry the IR wavelength radiation;
d) at least one optical resonator which recirculates the visible wavelength radiation; whereby
- the laser diode (2) or laser diode bar (8) and the upconversion layer(s) (4b) are arranged on the same substrate (3) or each on a separate substrate (3a, 3b),
- the laser diode (2) or laser diode bar (8) and the upconversion layer(s) (4b) are adjacently arranged, whereby a gap (7) between the adjacently arranged laser diode (2) or diode laser bar (8) and the upconversion layer(s) (4b) is formed; or
- the laser diode (2) or laser diode bar (8) and the upconversion layer(s) (4b) are contactingly arranged in this order;
- the upconversion layer comprises amorphous glass;
- the upconversion layer is placed between said two waveguide layers (4a, 4b) having a refractive index smaller than the refractive index of the upconversion layer; and
- the total thickness of the upconversion layer and the two waveguide layers is at least 1 µm thicker than the thickness of the emitting layer in the semiconductor diode laser; and
- the waveguide laser has a beam quality M² of ≥ 2 and ≤ 1000.

3. The waveguide laser according to one of the previous claims, further comprising at least one optical resonator which recirculates the IR wavelength radiation.

4. The waveguide laser according to one of the previous claims, whereby the semiconductor diode laser bar comprises at least 2, preferably at least 5, more preferably at least 10, most preferably at least 20 single diode laser emitters.

5. The waveguide laser that comprises a stack of at least 2 waveguide lasers according to one of the previous claims.

6. The waveguide laser according to one of claims 1 to 5, whereby the diode laser end facet is coated with an end mirror that is partially transmissive in the infrared, the upconversion layer end facet pointing to the IR diode laser end facet is coated with a highly reflective coating in the visible wavelength and highly transmissive in the infrared and the gap between the adjacent diode laser and upconversion layer is filled with a material translucent for visible wavelength radiation and/or infrared wavelength radiation whereby the filling material has preferably an index of refraction between the index of refraction of the diode laser or diode laser bar and the index of refraction of the upconversion layer.

7. The waveguide laser according to one of claims 1 to 6, whereby the diode laser end facet is coated with an end mirror that is partially transmissive in the infrared and highly reflective in the visible wavelength and the gap between the adjacent diode laser and upconversion layer is filled with a material translucent for visible wavelength radiation and infrared wavelength radiation whereby the filling material has index of refraction that differs not more than 0.2 from the index of refraction of the upconversion layer.

8. The waveguide laser according to one of claims 1 to 7, whereby
- a length of the upconversion layer that is ≥ 100 µm and ≤ 100,000 µm, preferably ≥ 200 µm, more preferably ≥ 500 µm and most preferably ≥1000 µm and ≤ 50,000 µm; and/or
- a width of the upconversion layer that has approximately the same width as the emitting layer of the diode laser, preferably >1 µm wider than the said emitter width, but not more than 200 µm wider than the said emitter width; and/or
- a thickness of the upconversion layer or, respectively, the total thickness of the upconversion layer and the two waveguide layers, that is by at least 1 µm thicker than the thickness of the emitting layer of the diode laser, preferably 2 µm thicker than said emitter thickness, but not more than 20 µm thicker than said emitter thickness.

9. The waveguide laser according to one of claims 1 to 8, whereby the diode laser bar and/or stacks are electro-conductively connected with one p-electrode and one n-electrode, or whereby the single diode laser emitters and/or stacks are electro-conductive connected separated from each other, or as individual groups or common in order to receive a desired activation.

10. The waveguide laser according to one of claims 1 to 9, whereby the waveguide laser comprises at least 3, preferably at least 15 upconversion layers, preferably each converts the IR wavelength into one colour of the primary colours red (R) green (G) or blue (B), more preferably the upconversion layers are adjacent arranged to produce a R-G-B pattern or the upconversion layers are adjacent arranged to produce an alternating R/GB or repeating R-G-B pattern.

11. A lighting unit comprising at least one of the waveguide lasers according to one of the claims 1 to 10, being designed for the usage in one of the following applications:
- shop lighting,
- home lighting,
- accent lighting,
- spot lighting,
- theater lighting,
- automotive headlighting,
- fiber-optics applications, and
- projection systems.

## Patentansprüche

1. Wellenleiterlaser, der aus IR-Wellenlängenstrahlung Strahlung im sichtbaren Wellenlängenbereich erzeugt, mit:
a) mindestens einem IR-Wellenlängenstrahlung erzeugenden Halbleiterdiodenlaser (2) oder Diodenlaserbarren (8), wobei die Emissionsschicht mindestens zwei Wellenleiterschichten umfasst;
b) mindestens einer Aufwärtskonvertierungsschicht (4), welche die IR-Wellenlängenstrahlung durch einen Prozess der Aufwärtskonvertierung des Photonenabsorptions-Energietransfers, gefolgt von Emission, in sichtbare Wellenlängen umwandelt;
c) mindestens einem optischen Resonator, der die Strahlung im sichtbaren Wellenlängenbereich wieder in Umlauf bringt; wobei
- die Laserdiode (2) oder der Laserdiodenbarren (8) und die Aufwärtskonvertierungsschicht(en) (4) auf dem gleichen Substrat (3) oder jeweils auf einem getrennten Substrat (3a, 3b) angeordnet sind;
- die Laserdiode (2) oder der Laserdiodenbarren (8) und die Aufwärtskonvertierungsschicht(en) (4) in Angrenzung aneinander angeordnet sind, wobei ein Zwischenraum (7) zwischen dem Diodenlaserbarren (8) und der (den) daneben angeordneten Aufwärtskonvertierungsschicht(en) (4) ausgebildet ist; oder
- die Laserdiode (2) oder der Laserdiodenbarren (8) und die Aufwärtskonvertierungsschicht(en) (4) in dieser Reihenfolge in Kontakt miteinander angeordnet sind;
- die Aufwärtskonvertierungsschicht amorphes Glas aufweist;
- die mindestens eine Aufwärtskonvertierungsschicht (4) eine Dicke aufweist, die mindestens 1 µm dicker als die Dicke der Emissionsschicht in dem Halbleiterdiodenlaser ist, und
- der Wellenleiterlaser eine Strahlqualität M² von ≥ 2 und ≤ 1000 hat.

2. Wellenleiterlaser, der aus IR-Wellenlängenstrahlung Strahlung im sichtbaren Wellenlängenbereich erzeugt, mit:
a) mindestens einem IR-Wellenlängenstrahlung erzeugenden Halbleiterdiodenlaser (2) oder Diodenlaserbarren (8), wobei die Emissionsschicht mindestens zwei Wellenleiterschichten umfasst;
b) mindestens einer Aufwärtskonvertierungsschicht (4), welche die IR-Wellenlängenstrahlung durch einen Prozess der Aufwärtskonvertierung des Photonenabsorptions-Energietransfers, gefolgt von Emission, in sichtbare Wellenlängen umwandelt;
c) mindestens zwei Wellenleiterschichten (4a, 4c), welche die IR-Wellenlängenstrahlung tragen;
d) mindestens einen optischen Resonator, der die Strahlung im sichtbaren Wellenlängenbereich wieder in Umlauf bringt; wobei
- die Laserdiode (2) oder der Laserdiodenbarren (8) und die Aufwärtskonvertierungsschicht(en) (4) auf dem gleichen Substrat (3) oder jeweils auf einem getrennten Substrat (3a, 3b) angeordnet sind;
- die Laserdiode (2) oder der Laserdiodenbarren (8) und die Aufwärtskonvertierungsschicht(en) (4) in Angrenzung aneinander angeordnet sind, wobei ein Zwischenraum (7) zwischen dem Diodenlaserbarren (8) und der (den) daneben angeordneten Aufwärtskonvertierungsschicht(en) (4) ausgebildet ist; oder
- die Laserdiode (2) oder der Laserdiodenbarren (8) und die Aufwärtskonvertierungsschicht(en) (4) in dieser Reihenfolge in Kontakt miteinander angeordnet sind;
- die Aufwärtskonvertierungsschicht amorphes Glas aufweist;
- die Aufwärtskonvertierungsschicht zwischen zwei Wellenleiterschichten (4a, 4c) mit einem kleineren Brechungsindex als diesem der Aufwärtskonvertierungsschicht positioniert ist; und
- die Gesamtdicke der Aufwärtskonvertierungsschicht und der beiden Wellenleiterschichten mindestens 1 µm dicker als die Dicke der Emissionsschicht in dem Halbleiterdiodenlaser ist; und
- der Wellenleiterlaser eine Strahlqualität M² von ≥ 2 und ≤ 1000 hat.

3. Wellenleiterlaser nach einem der vorangegangenen Ansprüche, welcher weiterhin mindestens einen optischen Resonator umfasst, der die IR-Wellenlängenstrahlung wieder in Umlauf bringt.

4. Wellenleiterlaser nach einem der vorangegangenen Ansprüche, wobei der Halbleiterdiodenlaserbarren mindestens 2, vorzugsweise mindestens 5, noch besser mindestens 10, am besten mindestens 20, einzelne Diodenlaseremitter umfasst.

5. Wellenleiterlaser, welcher einen Stapel aus mindestens 2 Wellenleiterlasem nach einem der vorangegangenen Ansprüche umfasst.

6. Wellenleiterlaser nach einem der Ansprüche 1 bis 5, wobei die Diodenlaser-Endfacette mit einem Endspiegel belegt ist, der in dem Infrarotbereich teilweise transmissiv ist, wobei die auf die IR-Diodenlaser-Endfacette gerichtete Endfacette der Aufwärtskonvertierungsschicht mit einer hoch reflektiven Beschichtung in dem sichtbaren Wellenlängenbereich überzogen und in dem Infrarotbereich hoch transmissiv ist und der Zwischenraum zwischen dem Diodenlaser und der benachbarten Aufwärtskonvertierungsschicht mit einem für sichtbare Wellenlängenstrahlung und/oder Infrarot-Wellenlängenstrahlung lichtdurchlässigen Material gefüllt ist, wobei das Füllmaterial vorzugsweise einen Brechungsindex zwischen dem Brechungsindex des Diodenlasers oder Diodenlaserbarrens und dem Brechungsindex der Aufwärtskonvertierungsschicht aufweist.

7. Wellenleiterlaser nach einem der Ansprüche 1 bis 6, wobei die Diodenlaser-Endfacette mit einem Endspiegel belegt ist, der in dem Infrarotbereich teilweise transmissiv und in dem sichtbaren Wellenlängenbereich hoch reflektiv ist und der Zwischenraum zwischen dem Diodenlaser und der benachbarten Aufwärtskonvertierungsschicht mit einem für sichtbare Wellenlängenstrahlung und Infrarot-Wellenlängenstrahlung lichtdurchlässigen Material gefüllt ist, wobei das Füllmaterial einen Brechungsindex aufweist, der von dem Brechungsindex der Aufwärtskonvertierungsschicht nicht mehr als 0,2 abweicht.

8. Wellenleiterlaser nach einem der Ansprüche 1 bis 7, welcher
- eine Länge der Aufwärtskonvertierungsschicht von ≥ 100 µm und ≤ 100.000 µm, vorzugsweises 200 µm, noch besser ≥ 500 µm ≤, am besten ≥ 1000 µm und ≤ 50.000 µm, und/oder
- eine Breite der Aufwärtskonvertierungsschicht, die in etwa die gleiche Breite wie die Emissionsschicht des Diodenlasers hat, vorzugsweise > 1 µm breiter als die Emitterbreite, jedoch nicht mehr als 200 µm breiter als die Emitterbreite, und/oder
- eine Dicke der Aufwärtskonvertierungsschicht oder jeweils die Gesamtdicke der Aufwärtskonvertierungsschicht und der beiden Wellenleiterschichten, die um mindestens 1 µm dicker als die Dicke der Emissionsschicht des Diodenlasers, vorzugsweise 2 µm dicker als die Emitterdicke, jedoch nicht mehr als 20 µm dicker als die Emitterdicke, ist,
aufweisen kann.

9. Wellenleiterlaser nach einem der Ansprüche 1 bis 8, wobei der Diodenlaserbarren und/oder die -stapel mit einer p-Elektrode und einer n-Elektrode elektrisch leitend verbunden sind, oder wobei die einzelnen Diodenlaseremitter und/oder - stapel getrennt voneinander oder als einzelne Gruppen oder gemeinsam elektrisch leitend verbunden sind, um eine gewünschte Aktivierung zu erhalten.

10. Wellenleiterlaser nach einem der Ansprüche 1 bis 9, wobei der Wellenleiterlaser mindestens 3, vorzugsweise mindestens 15, Aufwärtskonvertierungsschichten aufweist, vorzugsweise jede die IR-Wellenlänge in eine Farbe der Primärfarben Rot (R), Grün (G) oder Blau (B) umwandelt, noch besser die Aufwärtskonvertierungsschichten aneinander angrenzend angeordnet sind, um eine R-G-B-Struktur zu erzeugen, oder die Aufwärtskonvertierungsschichten aneinander angrenzend angeordnet sind, um eine abwechselnde R/G/B- oder sich wiederholende R-G-B-Struktur zu erzeugen.

11. Beleuchtungseinheit mit mindestens einem der Wellenleiterlaser nach einem der Ansprüche 1 bis 10, wobei diese zum Einsatz für eine der folgenden Anwendungen ausgeführt ist:
- Ladenbeleuchtung
- Beleuchtung für Zuhause
- Akzentbeleuchtung
- Punktbeleuchtung
- Theaterbeleuchtung
- Kraftfahrzeug-Scheinwerferbeleuchtung
- Faseroptik-Anwendungen sowie
- Projektionssysteme.

## Revendications

1. Laser guide d'ondes produisant un rayonnement à longueur d'onde visible à partir d'un rayonnement à longueur d'onde infrarouge comprenant :
a) au moins un laser à diode à semi-conducteur (2) ou une barrette de lasers à diode (8) produisant un rayonnement à longueur d'onde infrarouge, dans lequel la couche émettrice comprend au moins deux couches de guide d'ondes;
b) au moins une couche de conversion ascendante (4) qui convertit le rayonnement à longueur d'onde infrarouge en longueurs d'onde visibles par un processus de conversion ascendante de transfert d'énergie par absorption de photons suivie d'une émission;
c) au moins un résonateur optique qui recircule le rayonnement à longueur d'onde visible; de sorte que
- le laser à diode (2) ou la barrette de lasers à diode (8) et la ou les couches de conversion ascendante (4) sont agencés sur le même substrat (3) ou chacun sur un substrat séparé (3a, 3b);
- le laser à diode (2) ou la barrette de lasers à diode (8) et la ou les couches de conversion ascendante (4) sont agencés les uns à côté des autres, de sorte qu'un espace (7) se forme entre le laser à diode (2) ou la barrette de lasers à diode (8) et la ou les couches de conversion ascendante (4) agencés les uns à côté des autres, ou
- le laser à diode (2) ou la barrette de lasers à diode (8) et la ou les couches de conversion ascendante (4) sont disposées en contact dans cet ordre;
- la couche de conversion ascendante comprend du verre amorphe;
- l'épaisseur de la au moins une couche de conversion ascendante (4) est au moins 1 µm supérieure à l'épaisseur de la couche émettrice dans le laser à diode à semi-conducteur, et
- le laser guide d'ondes présente une qualité de faisceau M² ≥ 2 et ≤ 1000.

2. Laser guide d'ondes produisant un rayonnement à longueur d'onde visible à partir d'un rayonnement à longueur d'onde infrarouge comprenant :
a) au moins un laser à diode à semi-conducteur (2) ou une barrette de lasers à diode (8) produisant un rayonnement à longueur d'onde infrarouge, dans lequel la couche émettrice comprend au moins deux couches de guide d'ondes;
b) au moins une couche de conversion ascendante (4b) qui convertit le rayonnement à longueur d'onde infrarouge en longueurs d'onde visibles par un processus de conversion ascendante de transfert d'énergie par absorption de photons suivie d'une émission;
c) au moins deux couches de guide d'ondes (4a, 4c) qui portent le rayonnement à longueur d'onde infrarouge;
d) au moins un résonateur optique qui recircule le rayonnement à longueur d'onde visible; de sorte que
- le laser à diode (2) ou la barrette de lasers à diode (8) et la ou les couches de conversion ascendante (4b) sont agencés sur le même substrat (3) ou chacun sur un substrat séparé (3a, 3b);
- le laser à diode (2) ou la barrette de lasers à diode (8) et la ou les couches de conversion ascendante (4b) sont agencés les uns à côté des autres, de sorte qu'un espace (7) se forme entre le laser à diode (2) ou la barrette de lasers à diode (8) et la ou les couches de conversion ascendante (4b) agencés les uns à côté des autres, ou
- le laser à diode (2) ou la barrette de lasers à diode (8) et la ou les couches de conversion ascendante (4b) sont disposés en contact dans cet ordre;
- la couche de conversion ascendante comprend du verre amorphe;
- la couche de conversion ascendante est placée entre lesdites deux couches de guide d'ondes (4a, 4c) ayant un indice de réfraction inférieur à l'indice de réfraction de la couche de conversion ascendante, et
- l'épaisseur totale de la couche de conversion ascendante et des deux couches de guide d'ondes est au moins 1 µm supérieure à l'épaisseur de la couche émettrice dans le laser à diode à semi-conducteur, et
- le laser guide d'ondes présente une qualité de faisceau M² ≥ 2 et ≤ 1000.

3. Laser guide d'ondes suivant l'une quelconque des revendications précédentes, comprenant en outre au moins un résonateur optique qui recircule le rayonnement à longueur d'onde infrarouge.

4. Laser guide d'ondes suivant l'une quelconque des revendications précédentes, par lequel la barrette de lasers à diode à semi-conducteur comprend au moins 2, de préférence au moins 5, plus préférablement au moins 10 et très préférablement au moins 20 émetteurs lasers à diode uniques.

5. Laser guide d'ondes comprenant une pile d'au moins 2 lasers guides d'ondes suivant l'une quelconque des revendications précédentes.

6. Laser guide d'ondes suivant l'une quelconque des revendications 1 à 5, par lequel la facette d'extrémité du laser à diode est recouverte d'un miroir d'extrémité qui est partiellement transmissif dans le domaine de l'infrarouge, la facette d'extrémité de la couche de conversion ascendante dirigée vers la facette d'extrémité du laser à diode infrarouge est recouverte d'un revêtement hautement réfléchissant dans la longueur d'onde visible et hautement transmissif dans le domaine de l'infrarouge et l'espace entre le laser à diode et la couche de conversion ascendante adjacents est rempli d'un matériau transparent au rayonnement à longueur d'onde visible et/ou au rayonnement à longueur d'onde infrarouge de sorte que le matériau de remplissage présente de préférence un indice de réfraction compris entre l'indice de réfraction du laser à diode ou de la barrette de lasers à diode et l'indice de réfraction de la couche de conversion ascendante.

7. Laser guide d'ondes suivant l'une quelconque des revendications 1 à 6, par lequel la facette d'extrémité du laser à diode est recouverte d'un miroir d'extrémité qui est partiellement transmissif dans le domaine de l'infrarouge et hautement réfléchissant dans la longueur d'onde visible et l'espace entre le laser à diode et la couche de conversion ascendante adjacents est rempli d'un matériau transparent au rayonnement de longueur d'onde visible et au rayonnement de longueur d'onde infrarouge de sorte que le matériau de remplissage présente un indice de réfraction qui diffère au maximum de 0,2 de l'indice de réfraction de la couche de conversion ascendante.

8. Laser guide d'ondes suivant l'une quelconque des revendications 1 à 7, par lequel
- la longueur de la couche de conversion ascendante est ≥ 100 µm et ≤ 100 000 µm, de préférence ≥ 200 µm, plus préférablement ≥ 500 µm et très préférablement ≥ 1000 µm et ≤ 50 000 µm, et/ou
- la largeur de la couche de conversion ascendante est approximativement identique à celle de la couche émettrice du laser à diode, de préférence >1 µm plus large que ladite largeur de l'émetteur, mais pas plus que 200 µm plus large que ladite largeur de l'émetteur, et/ou
- l'épaisseur de la couche de conversion ascendante ou, respectivement, l'épaisseur totale de la couche de conversion ascendante et des deux couches de guide d'ondes est au moins 1 µm supérieure à l'épaisseur de la couche émettrice du laser à diode, de préférence 2 µm supérieure à ladite épaisseur de l'émetteur, mais pas plus que 20 µm supérieure à ladite épaisseur d'émetteur.

9. Laser guide d'ondes suivant l'une quelconque des revendications 1 à 8, par lequel la barrette de lasers à diode et/ou les piles sont connectées par conduction d'électricité à une électrode du type P et une électrode du type N, ou par lequel les émetteurs lasers à diode uniques et/ou les piles sont connectés par conduction d'électricité séparément les uns des autres, ou sous la forme de groupes individuels ou en commun afin de recevoir une activation souhaitée.

10. Laser guide d'ondes suivant l'une quelconque des revendications 1 à 9, par lequel le laser guide d'ondes comprend au moins 3, de préférence au moins 15 couches de conversion ascendante, convertissant de préférence chacune la longueur d'onde infrarouge en une couleur des couleurs primaires rouge (R), verte (G) ou bleue (B), plus préférablement les couches de conversion ascendante sont agencées les unes à côté des autres pour produire un motif R-G-B ou les couches de conversion ascendante sont agencées les unes à côté des autres pour produire un motif alternativement R/G/B ou un motif successivement R/G/B.

11. Unité d'éclairage comprenant au moins un des lasers guides d'ondes suivant l'une quelconque des revendications 1 à 10, étant conçue pour être utilisée dans une des applications suivantes :
- éclairage pour magasin;
- éclairage domestique;
- éclairage localisé;
- éclairage à faisceau concentré;
- éclairage cinématographique;
- phares automobiles avant;
- applications à fibres optiques, et
- systèmes de projection.
